# EUROPEAN PATENT SPECIFICATION

(11) **EP 3 208 134 B1**
(45) Date of publication and mention of the grant of the patent: **01.01.2020**
(21) Application number: 17155038.7
(22) Date of filing: 07.02.2017
(51) Int. Cl.: B60K 35/00, B60K 37/04, B60R 13/02, B60R 13/04, B82Y 20/00, H01L 51/50, B60Q 3/14, B60R 13/00

(54) **A DISPLAY SCREEN FOR A VEHICLE**
ANZEIGEBILDSCHIRM FÜR EIN FAHRZEUG
ÉCRAN D'AFFICHAGE DESTINÉ À UN VÉHICULE

(30) Priority: 17.02.2016 GB 201602797
(43) Date of publication of application: 23.08.2017
(73) Proprietor: Ford Global Technologies, LLC, Dearborn, MI 48126 (US)
(72) Inventor: FEARNS, Liberty, London, E6 1NY (GB); KELLY, Steven, London, EC2A 3HP (GB); NOLLER, Felix, London, E15 4NA (GB)
(74) Representative: Haseltine Lake Kempner LLP

(56) References cited:
- JP-A- 2000 111 447
- US-A1- 2011 066 324
- US-A1- 2015 257 210
- US-B1- 8 933 819

## Description

### Technical Field

The present disclosure relates to a display screen for a vehicle and is particularly, although not exclusively, concerned with a display screen for a vehicle configured to be applied to a trim panel of the vehicle, e.g. using a thermo-forming process.

### Background

Trim panels, such as body panels of vehicles, e.g. motor vehicles, are often painted in order to protect the trim panels from corrosion or abrasion, as well as to give an improved appearance to the vehicle. The colour of the vehicle is often selected by the owner when purchasing the vehicle according to their own personal tastes. Repainting vehicles is costly and hence vehicles often remain the same colour during the entire length of their use, even if the owner, or the owner's colour preference changes.

US8933819B1 discloses a method and apparatus for displaying information on an exterior surface of an aircraft in which a display panel is embedded within the exterior surface of the aircraft. US2015/0257210A1 discloses electroluminescent layer constructions for displays and lighting. JP2000111447A discloses an image inspection device and method with improved calibration method. US2011/0066324 discloses a system and method for customizing the appearance of a vehicle.

### Statements of Invention

According to an aspect of the present disclosure, there is provided a Quantum Dot (QD) display screen for a trim panel of a vehicle, e.g. a motor vehicle, the display screen comprising: a first layer comprising a formable polymer substrate; a second layer comprising an electric circuit, wherein the second layer is formed onto the first layer; and a third layer comprising a plurality of quantum dots configured to emit light, the electric circuit configured to control the emission of light; wherein the display screen is configured to be formed onto the trim panel of the vehicle. The display screen follows the visible contours of the trim panel, e.g. visible to the end user of the vehicle. The display screen at least partially covers the trim panel. One or more of the quantum dots are configured to absorb light and generate a voltage across the one or more quantum dots.

The trim panel may be an interior panel or an exterior panel, e.g. a body panel, of the vehicle. The trim panel may be at least partially structural and/or aesthetic.

The substrate may comprise a thermo-formable polymer. For example, the substrate may comprise a vinyl material.

The electric circuit may be a thin-film circuit, such as a thin film transistor circuit, e.g. an organic thin film circuit.

The display screen may further comprise a light emitting layer comprising a plurality of light emitting elements. The light emitting layer may be provided between the second layer and the third layer.

The display screen may comprise a plurality of QD pixels. Each QD pixel may comprise one or more quantum dots.

Each of the QD pixels may comprise one or more electro-active QD elements. The electro-active QD elements may comprise one or more quantum dots. The electro-active QD elements may be configured to receive a signal from the electric circuit and emit light. For example, the QD elements may further comprise one or more additional semiconductor elements and may be configured to form quantum dot Light Emitting Diodes (LEDs).

The QD pixels may each comprise three or more electro-active QD elements, e.g. one electro-active QD element for each primary colour. Each of the electro-active QD elements may be configured to emit light of a different frequency. Each of the quantum dots within each QD element may be configured to emit substantially the same frequency of light as the other quantum dots within the QD element.

Additionally or alternatively, the QD pixels may each comprise one or more photo-active QD elements. The photo-active QD elements may comprise one or more quantum dots. The photo-active QD elements may be configured to absorb and emit light.

Each of the photo-active QD elements may be configured to receive light from one or more of the light emitting elements. The QD pixels may each comprise two or more photo-active QD elements, each configured to emit light of a different frequency. For example, each QD pixel may comprise 3 photo-active QD elements, one for each primary colour. Alternatively, each QD pixel may comprise 2 photo-active QD elements and one space. The space may be configured to allow light from the light emitting layer to pass through the third layer without being absorbed, e.g. by the quantum dots.

The display screen may further comprise a pigment layer. The pigment layer may be provided between the second layer and the third layer. Alternatively, the pigment layer may be provided between the first and second layer.

The display screen may further comprise a protective coating layer provided on an outer surface of the display screen, e.g. over the third layer.

The second layer may further comprise a plurality of nanowires electrically coupled to the electric circuit. The nanowires may communicatively couple the electric circuit to the QD pixels. The nanowires may allow the operation of the QD pixels to be controlled.

The second layer may comprise a plurality of pixel controllers, wherein each of the pixel controllers is configured to control a respective QD pixel. Each of the pixel controllers may be communicatively coupled to at least two other pixel controllers. Each of the pixel controllers may be communicatively coupled to the other pixel controllers within a matrix, such as an active matrix.

The display screen may further comprise a display screen controller coupled to the electrical circuit. The display screen controller may be configured to control the operation of each of the QD pixels, e.g. via the pixel controllers. The display screen controller may control the colour and/or brightness of each of the QD pixels.

One or more of the quantum dots is configured to absorb light, e.g. light falling on to the display screen, such as solar light, and generate a voltage across the one or more quantum dots. In other words, one or more of the quantum dots may be configured to form QD solar cells.

The electric circuit may be configured to receive electrical power from the third layer, e.g. from the QD solar cells.

According to another aspect of the present disclosure, there is provided a display trim panel for a vehicle, the display trim panel comprising: the display screen according to any of the previously mentioned aspects of the disclosure; and the trim panel for the vehicle, wherein the display screen is formed onto the trim panel of the vehicle such that the display screen follows the visible contours of the trim panel, the display screen at least partially covering the trim panel.

The display screen may be formed onto the trim panel using a thermo-forming process. The trim panel may be a body panel of the vehicle. The display screen may be formed onto an exterior surface of the body panel. Alternatively, the trim panel may be an interior panel of the vehicle. The display screen may be formed onto a visible surface of the interior panel, e.g. an interior surface of the vehicle such as a dashboard, centre console or ceiling.

The QD display screen may configured to be illuminated to provide one or more lights of the vehicle. The lights may include, but are not limited to, a head light, a fog light, a side light, a reversing light, a brake light, an indicator light, such as a front, rear or side indicator light, a running light, a tail light or an interior light.

According to another aspect of the disclosure, there is provided a method of manufacturing a display trim panel for a vehicle, the method comprising: manufacturing a Quantum Dot display screen; wherein manufacturing the Quantum Dot display screen comprises: providing a first layer comprising a formable polymer substrate; forming a second layer onto the polymer substrate, wherein the second layer comprises an electric circuit; and forming a third layer over the second later, wherein the third layer comprises a plurality of quantum dots configured to emit light, the electric circuit configured to control the emission of light, and wherein one or more of the quantum dots are configured to absorb light and generate a voltage across the one or more quantum dots; wherein the method of manufacturing the display trim panel further comprises: providing a trim panel of the vehicle; forming the Quantum Dot display screen on to the trim panel, such that the display screen follows the visible contours of the trim panel, the display screen at least partially covering the trim panel.

The display screen may be formed on to the trim panel of the vehicle using a thermo-forming process.

The second layer may be formed onto the first layer using an additive manufacturing process. The third layer may be formed over the second layer using an additive manufacturing process. For example, the second and/or third layer may be formed using an inkjet process, such as a bubblejet process. The third layer may be formed onto, e.g. directly onto, the second layer. Alternatively, there may be an intermediate layer, such as a light emitting layer or a pigment layer.

The method may further comprise providing a plurality of nanowires within the third layer. The nanowires may be electrically coupled to the second layer. The nanowires may couple the electric circuit to the QD pixels, e.g. the quantum dots or quantum dot elements. The nanowires may be provided using an additive manufacturing process.

Manufacturing the display screen may further comprise: providing a protective coating at least partially over an outer surface of the display screen.

The method may further comprise, providing an aperture in the display screen. Providing an aperture in the display screen may comprise severing one or more electrical connections within the electric circuit, e.g. connections between the pixel controllers.

The method may further comprise coupling a display screen controller to the display screen. The method may further comprise calibrating the display screen controller according to the position and/or orientation of the display screen relative to the trim panel and/or vehicle.

The method may comprise:
(a) selecting one or more pixels of the display screen to be calibrated;
(b) controlling the display screen to activate the selected pixels, such that the selected pixels becomes illuminated;
(c) determining locations of the selected pixels relative to a location on the trim panel and/or vehicle;
(d) associating the locations of the selected pixels with addresses associated with the selected pixels.

The address may relate to a number associated with the pixel, e.g. the pixel controller or may represent a physical address of the pixel within an array of pixels on the display screen. The pixels that are not selected may not be illuminated, or may be illuminated with a difference brightness. Additionally or alternatively, the selected pixels may be illuminated in a different colour to the others of the pixels, e.g. a contrasting colour. The associated locations and addresses may be stored in a memory associated with the display screen.

The steps of the method may be repeated until locations of substantially all of the pixels of the display screen have been associated with respective addresses. The one or more pixels may be selected using an optimised search method. For example such that the steps of the method may be repeated the least number of times in order to determine the locations of substantially all of the pixels.

Step (c) may comprise: capturing an image of the trim panel or vehicle; processing the image to determine locations of the activated pixels relative to a location on the trim panel or vehicle.

The method may further comprise storing the associated locations and addresses on a memory associated with the display screen, e.g. a memory of a controller of the display screen.

The motor vehicle according to a previously mentioned aspect of the disclosure may further comprise a controller configured to perform the method according to any previously mentioned aspects of the disclosure.

### Brief Description of the Drawings

For a better understanding of the present invention, and to show more clearly how it may be carried into effect, reference will now be made, by way of example, to the accompanying drawings in which:
Figure 1 shows a vehicle comprising one or more display trim panels, according to arrangements of the present disclosure;
Figure 2 is a sectional perspective view of a quantum dot display screen, according to an arrangement of the present disclosure;
Figure 3 is a sectional perspective view of a quantum dot display screen, according to another arrangement of the present disclosure;
Figure 4 shows a method for manufacturing a display trim panel for a vehicle, according to arrangements of the present disclosure;
Figure 5 shows a method for manufacturing a display screen for a panel of a vehicle, according to arrangements of the present disclosure;
Figure 6 shows a method for calibrating a display screen or a display trim panel for a vehicle, according to arrangements of the present disclosure;
Figure 7 is a schematic view of a system for controlling the illumination of a plurality of QD display panels provided on a vehicle, according to arrangements of the present disclosure;
Figure 8 shows a method for calibrating a vehicle display screen controller, according to arrangements of the present disclosure;
Figure 9 shows a method for illuminating a display trim panel, according to an arrangement of the present disclosure;
Figure 10 shows a method for illuminating a display trim panel, according to an arrangement of the present disclosure; and
Figure 11 shows a method for illuminating a display trim panel according to an arrangement of the present disclosure.

### Detailed Description

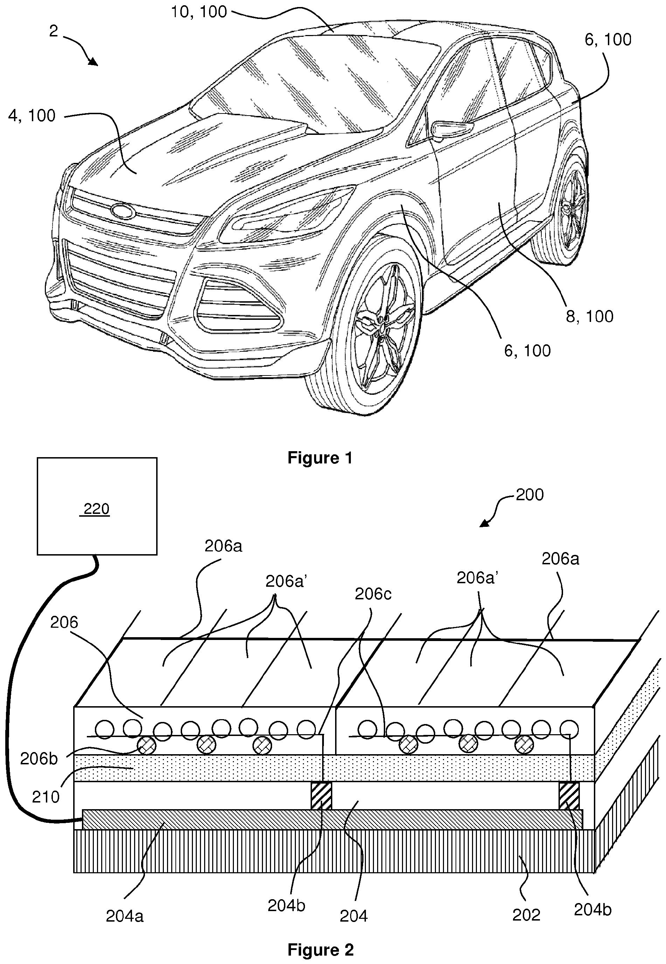

With reference to Figure 1, a vehicle, such as a motor vehicle 2 comprises one or more trim panels, including exterior panels, such as a bonnet 4, wings 6 door panels 8, and roof 10 and/or interior panels, such as a dash panel and a console panel. The trim panels may be at least partially structural and/or may be at least partially aesthetic. It is often desirable to paint panels of a vehicle in order to improve the appearance of the vehicle and/or to protect from damage or corrosion.

As depicted in Figure 1, one or more of the trim panels 4, 6, 8, 10 comprise Quantum Dot (QD) display trim panels 100. In addition to or instead of painting the trim panels, each of the QD display trim panels 100 may be provided with a display screen, such as a QD display screen 200 depicted in Figure 2. The QD display screen is configured to be formed onto the trim panel of the vehicle such that the display screen follows the visible contours of the trim panel. One or more of the trim panels may be curved and the QD display screen may be applied to the curved surface. The QD display screen 200 is configured to at least partially cover the trim panel of the vehicle 2.

In some arrangements, the QD display screen may be configured to cover a window of the vehicle, such as a windscreen, side window or rear window of the vehicle. The QD display screen may also be configured to cover bumpers or any other surface of the vehicle. References in this specification to trim panels may also refer to windows, bumpers or any other surface of the vehicle.

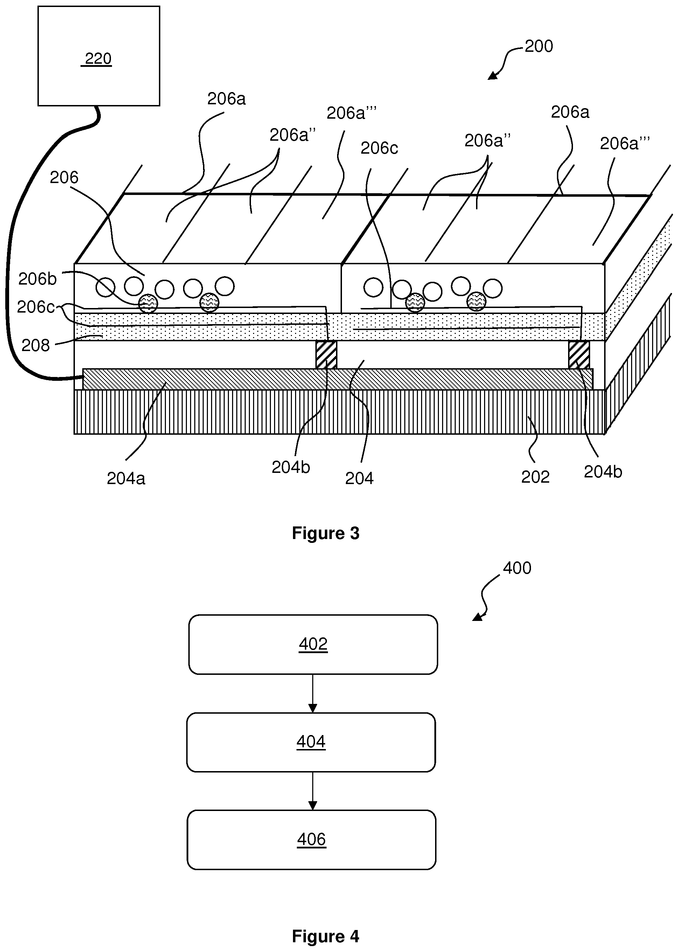

With reference to Figures 2 and 3, the QD display screen 200, according to arrangements of the present disclosure, comprises a plurality of layers. The display screen comprises a first layer 202, which comprises a substrate, such as a polymer substrate, a second layer 204, which comprises an electric circuit 204a, and a third layer, which comprises a plurality of quantum dots. The first layer 202 may be provided on an inside of the QD display screen 200 and the third layer 206 may be provided at an outside of the QD display screen (i.e. the side closest the viewer).

Quantum dots are nanoscale particles of semiconductor materials, e.g. semiconductor devices, which exhibit quantum mechanical properties. Quantum dots tightly confine electrons or holes in all three spatial dimensions. In a semiconductor crystallite whose size is smaller than twice the size of its exciton Bohr radius, such as a quantum dot, the excitons are squeezed leading to quantum confinement.

The quantum mechanical properties of quantum dots allow them to be tuned to emit light of a specific frequency when excited by absorbing light and/or by an electrical signal. The size and/or shape of the quantum dots may determine the frequency of light emitted and/or absorbed by the quantum dots. Quantum dots may be formed from semi-conductor materials such as lead sulphide, lead selenide, cadmium selenide, cadmium sulphide, indium arsenide, or indium phosphide

In the arrangement shown in Figure 2, the quantum dots provided in the third layer 206 are configured to form a plurality of QD pixels 206a. The QD pixels 206a comprise one or more electro-active QD elements 206a', such as QD Light Emitting Diodes (LEDs). Each of the electro-active QD elements 206a' may be configured to emit light at a predetermined frequency when provided with, e.g. excited by, an electrical signal. Each of the QD elements 206a' may in turn comprise one or more quantum dots. Each of the quantum dots provided in each of the electro-active QD elements 206a' may be configured to emit light of substantially the same frequency as the other quantum dots provided in the electro-active QD element.

As depicted in Figure 2, the QD pixels 206a may each comprise three electro-active QD elements 206a'. Each of the QD elements 206a' may be configured to emit a different frequency of light when provided with an electric signal input. For example, the electro-active QD elements 206a' may be configured to emit red, green and blue light respectively. Providing three electro-active QD elements 206a' within each QD pixel may allow each QD pixel to appear to be emitting light of any colour within the visible spectrum by controlling the relative intensities of the different frequencies of light being emitted. It is also envisaged that the QD pixels may comprise one, two or more than three electro-active QD elements if desired.

With reference to Figure 3, in an alternative arrangement, the QD display screen 200 may comprise a light emitting layer 208. The light emitting layer 208 may be provided between the second layer 204 and the third layer 206. The light emitting layer 208 may be configured to emit light towards the third layer 206, e.g. towards the QD pixels 206a.

The light emitting layer 208 may comprise a plurality of LEDs, such as organic LEDs. Alternatively, the light emitting layer 208 may comprise other light emitters, such as electroluminescent panels.

In the arrangement shown in Figure 3, the QD pixels 206a each comprise one or more photo-active QD elements 206a" configured to receive light, e.g. from the light emitting layer 208, and emit light at one or more frequencies. The frequency of light emitted by each of the photo-active QD elements 206a" may be different from the other photo-active QD elements of the QD pixel 206a. Each of the quantum dots provided in each of the photo-active QD elements 206a" may be configured to emit light of substantially the same frequency. The frequency of light emitted by each of the photo-active QD elements 206a" may also be different from the frequency of light emitted from the light emitting layer 208. For example, the light emitting layer may be configured to emit light at the frequency of visible blue light and the photo-active QD elements 206a" may be configured to absorb blue light and emit light at the frequencies of visible green light or visible red light.

Each of the QD pixels 206a may comprise two photo-active QD elements 206a". For example, each of the QD pixels 206a may comprise a photo-active QD element configured to absorb blue light and emit green light and a photo-active QD element configured to absorb blue light and emit red light Each of the QD pixels 206a may also comprise a space 206a"', which does not comprise a QD element, e.g. where no quantum dots are provided. Providing a space may allow the light from the light emitting layer 208 to pass though the QD pixel 206a without being absorbed. Providing the two photo-active QD elements described above and the space 206a'" may allow each QD pixel to appear substantially any colour within the visible spectrum.

The light emitting layer 208 may comprise a plurality of light emitting elements (not shown), which correspond to the photo-active QD elements 206a" and the space 206a'"' of each of the QD pixels. Each of the QD pixels 206a may be considered to comprise the one or more light emitting elements provided within the light emitting layer 208, which correspond to the QD elements 206a" and the space 206a'" of the QD pixel 206a. References within this specification to control of the QD pixels 206a may relate to control of the corresponding light emitting elements of the light emitting layer 208.

In either arrangement, one or more of the quantum dots provided in the third layer 206 may be configured to form one or more QD solar cells 206b. The QD solar cells are configured to absorb light falling upon the QD display screen 200, from a source external to the QD display screen 200, such as solar light, and generate an electric voltage across the QD solar cell 206b. In some arrangements, the QD pixels 206a may comprise the QD solar cells 206b. For example, the QD pixels 206a, or one or more of the QDs within the QD pixels 206a, may be configured to act as solar cells when they are or are not emitting light. Additionally or alternatively, the QD solar cells 206b may be provided separately from the QD pixels 206a. For example, the QD solar cells may be provided between the QD pixels and/or may be provided inside of or outside of the QD pixels 206a, relative to the layers of the QD display screen 200. As depicted in Figures 2 and 3, the QD solar cells 206b may be provided within the third layer 206. However, it is also envisaged that the QD display screen 200 may comprise a solar cell layer (not shown). The solar cell layer may be provided inside of or outside of the third layer 206.

In order to improve the appearance of the trim panel of the vehicle when the QD pixels 206a are not emitting light, the QD display screen 200 may comprise a pigment layer 210. The pigment layer 210 may comprise a thin film layer, e.g. with an impregnated pigment of a particular colour. The pigment layer 210 may be provided inside of the third layer 206, e.g. between the third layer and the second layer 204. The third layer 206, e.g. the quantum dots within the third layer 206, may be substantially transparent.

Hence, the pigment layer 210 may be visible when the QD pixels 206a are not emitting light. The pigments layer 210 may be provided in the arrangement depicted in Figure 2 with the electro-active EQ elements 206a'.

With reference to Figure 2, the second layer 204 and/or the third layer 206 may further comprise a plurality of nanowires 206c, such as silver nanowires. The nanowires 206c may be configured to communicatively couple the quantum dots, e.g. the electro-active QD elements 206a' and/or solar cells 206b, to the electric circuit 204a. The nanowires 206c may be configured to transmit control signals from the electric circuit 204a to the QD pixels 206a, e.g. to control the operation of the QD pixels according to signals provided by the electric circuit 204a. Additionally or alternatively, the nanowires 206c may be configured to transmit an electric current driven by the voltage across QD solar cells 206b to the electric circuit 204a.

As shown in Figure 3, when the QD display screen 200 comprises the light emitting layer 208, the nanowires 206c may be provided within the light emitting layer 208. The QD display may be controlled by controlling the operation of the light emitting elements of the light emitting layer 208 via the nanowires 206c.The photo-active QD elements 206a" may not be coupled to the nanowires 206c since the photo-active QD elements are selectively activated by the light emitting elements beneath.

The electric circuit 204a provided in the second layer 204 may comprise a thin-film circuit, such as a thin-film transistor circuit. In the arrangements shown in Figures 2 and 3, the electric circuit 204a is an organic thin film transistor circuit. The thin-film circuit may comprise a plurality of pixel controllers 204b. The pixel controllers 204b may be configured to control the operation of the QD pixels 206a. For example, the pixel controllers 204b may be configured to control the brightness and/or colour of the illuminated QD pixels 206a, 208b. Each of the pixel controllers may be communicatively coupled, e.g. electrically coupled, to a corresponding QD pixel 206a. The pixel controllers 204b may be configured to control the operation of the corresponding QD pixel 206a. The pixels controllers 204a may be coupled to the QD pixels 206a using the nanowires 206c.

Each of the pixel controllers 204b may be communicatively coupled to one or more of the other pixel controllers 204b to allow control signals to be transmitted between the pixel controllers. In the arrangements shown in Figures 2 and 3, each of the pixel controllers is communicatively coupled to two or more of the other pixel controllers 204b.

The pixel controllers 204b may be arranged in a matrix and may be coupled to each of the adjacent pixel controllers 204b in the matrix. For example, the pixel controllers may be arranged in a rectangular, hexagonal, octagonal matrix, or any other regular or irregular matrix.

Coupling each of the pixel controllers 204b to at least two of the other pixel controllers 204b may introduce redundancy into the system, such that multiple paths are available for control signals to be transmitted between the pixel controllers. This may allow control signals to be transmitted between each of the pixel controllers even if a portion of the display is removed, e.g. disconnected. Such disconnections may occur during manufacture of the QD display trim panel 100, as described with reference to Figure 4 below.

In another arrangement of the disclosure, the pixel controllers 204b may be arranged and/or may be coupled with others of the pixel controllers 204b in a branched or hierarchical structure of connections. When providing the connections between pixel controllers, the connections may be defined in order to provide the shortest communication paths between each of the pixel controllers 204b, whilst incorporating the greatest amount of redundancy of connections into the electric circuit 204a.

In use of the QD display screen 200, e.g. when the QD display screen is processing control signals, each pixel controller 204b may be configured to transmit signals to one of the other pixel controller 204b it is connected to. Each of the connections from one pixel controller 204b to the other pixel controllers may have a priority and the pixel controller 104b may attempt to transmit the signal using each of the connections in order of priority until the signal has been successfully transmitted to another pixel controller 104b. By configuring each of the pixel controllers 204b to transmit signals in this way, the order in which the pixel controllers receive the signals may be consistent for each signal. This may be important when the pixels are being addressed according to the order in which they process the control signal, as described below.

In another arrangement of the present disclosure, the pixel controllers 204b may be configured to transmit control signals using each of the available connections, such that multiple communication paths are used between pixel controllers 204b. When using this method, the reliability of the transmission of the control signals to each of the pixel controllers 204b may be improved.

In order to make use of the multiple communication paths available, it may be necessary to implement an addressing scheme for the pixel controllers that is resilient to changes in the order in which the pixel controllers 204b receive the control signals. Different methods for addressing pixel controllers 204b within the QD display screen 200 are discussed in more detail below.

A display controller 220 may be coupled to the QD display screen 200 and may be configured to control the operation of each of the QD pixels 206a via the pixel controllers 204b. The display controller 220 may be coupled to the QD display screen 200 at a single location, e.g. to a single pixel controller 204b. The display controller 220 may be coupled to the electric circuit 204a at or towards one or more edges of the QD display screen 200, e.g. at a corner of the QD display screen. In some arrangements, the display controller 220 may be coupled to more than one pixel controller 204a, e.g. provided at or towards one or more edges of the QD display screen 200. For example, the display controller 220 may be coupled to each of the pixel controllers 204b provided along two edges of the QD display screen.

The pixel controllers 204b may be identified by the display controller 220, e.g. addressed, according to their position in the matrix of pixel controllers 204b relative to the display controller 220, e.g. relative to a connection between the display controller 201 and the matrix of pixel controllers 204b. For example, the pixel controllers 204b may be identified by the order in which a signal sent from the display controller 220 to the QD display screen 200 reaches each of the pixel controllers 204b. Additionally or alternatively, each of the pixel controllers 204b may include an individual pixel identity, e.g. stored on a memory of the pixel controller 204b, which allows each of the pixel controllers 204b to be directly identified and addressed irrespective of the order in which the control signal is received by the pixel controllers 204b.

In some arrangements, the display controller 220 may address the pixel controllers 204b using a matrix addressing scheme, such as an active matrix addressing scheme. Alternatively, the display controller may address the pixel controllers 204b using any other addressing scheme. The display controller 220 may communicate with the matrix of pixel controllers 204a using a data bus, e.g. a parallel data bus or a serial data bus, such as a multidrop bus.

In the arrangements shown in Figures 2 and 3, the pixel controllers 204b and/or the connections between each of the pixel controllers 204b within the matrix of pixel controllers are configured such that a signal received from the display controller 220 is transmitted between the pixel controllers 204b until the signal has been received by substantially every pixel controller 204b. Each pixel controller 204b may transmit the signal to one of the pixel controllers 204b adjacent to it, such that the signal is received by the pixel controllers 204b sequentially. In some arrangements, the pixel controllers 204b may be configured such that the order in which the control signals is transmitted between the pixel controllers 204b, e.g. the route through which the control signal propagates through the matrix of pixel controllers is the same for each control signal. In this case, the control signal may comprise a series of pixel instructions and the order of the pixel instructions within the signal may correspond to the order of the pixel controllers 204b within the addressing scheme.

When the control signal is received by each pixel controller, the pixel controller may process the first pixel instruction in the received signal and may transmit the control signal to the next pixel controller omitting the first pixel instruction, e.g. omitting the pixel instruction it has processed. The control signal may therefore be configured to comprise a number of pixel instructions equal to the number of pixel controllers 204b within the QD display screen 200.

In an alternative arrangement, the control signals may comprise one or more pixel instructions and one or more pixel identifiers, which identify the pixel controllers 204a intended to receive each of the instructions. When the control signals are received by each of the pixel controllers 204b, the pixel controller may compare the pixel identifier of the control signal with the pixel identity of the pixel controller 204b. If the pixel identifier matches the pixel identity, the pixel controller 204b may process the pixel instruction, otherwise, the pixel controller may transmit the control signal to one or more other, e.g. adjacent, pixel controllers 204a. Control signals may thereby be propagated through the network of pixel controllers 204b until the signal is received and processed by the pixel controller it is addressed to.

If the pixel controllers 204b transmit the control signal to two or more pixel controllers adjacent to it, the controller signal may propagate through the matrix of pixel controllers 204b via multiple routes at the same time. Hence, the control signal may be received and/or processed by multiple pixel controllers 204b at substantially the same time.

In some cases, control signals may be addressed to multiple pixel controllers. In this case, the pixel controllers may transmit the signal to further pixel controllers after the signal has been processed, e.g. without omitting the processed pixel instruction.

It may be desirable to ensure that each control signal is only considered, e.g. processed and/or transmitted, once by each pixel controller 204b. Hence, the control signals may also comprise a signal identifier. Each of the control signals provided by the display controller 220 may be given a signal identifier. The pixel controllers 204b may be configured to consider the signal identifier and to disregard any signals comprising signal identifiers which have already been considered, e.g. processed and/or transmitted. The signal identifier may indicate the order in which the signal was sent and the pixel controllers 204b may be configured not to consider signals that are older than previously considered signals.

It is also envisaged that other methods of communicating control signals to the intended pixel controllers 204b may be implemented. Additionally or alternatively, other methods may be used to ensure each control signal is only processed the desired number of times by each pixel controller 204b.

The electric circuit 204a may also be configured to receive electric power from the QD solar cells 206b. For example, each of the pixel controllers 204b may be communicatively coupled, e.g. electrically coupled, to one or more QD solar cells 206b and may receive electric power from the QD solar cells 206b. The QD display screen 200 may be coupled to an energy storage device (not shown) and the electric circuit 204a may be configured to transmit the electric power to the energy storage device. As described above, the QD pixels 206a may be configured to act as QD solar cells 206b when they are or are not being controlled to emit light. Hence, the connections between the QD pixels 206a and the pixel controllers 204b may also be used to transmit power from the QD pixels 206a to the electric circuit 204a when the QD pixels 206a are acting as QD solar cells 206b

With reference to Figure 4, a method 400 for manufacturing a display trim panel for a vehicle, according to arrangements of the present disclosure will now be described. The method 400 comprises a first step 402 in which a display screen, such as the QD display screen 200 is manufactured. In a second step 404 the trim panel of the vehicle is provided. In a third step 406, the display screen is formed onto the trim panel.

The polymer substrate of the first layer 202 may comprise a thermo-formable polymer, such as vinyl. As mentioned above, the QD display screen may be configured to at least partially cover one or more panels 4, 6, 8, 10, 12, 14 of the vehicle. The QD display screen 100 may be formed onto the trim panels of the vehicle, e.g. using a thermo-forming process.

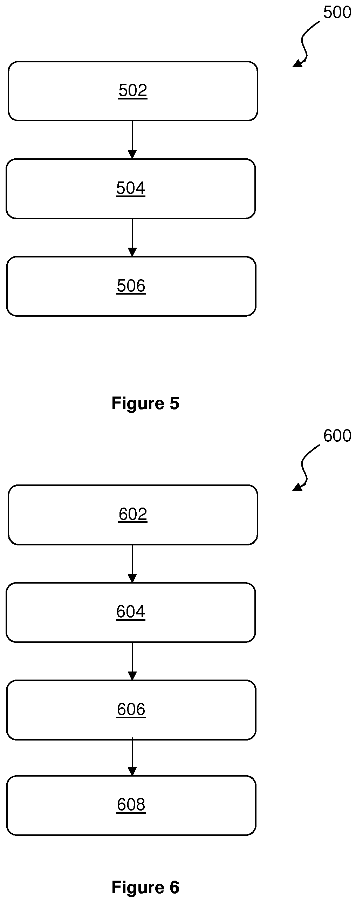

The first step 402 may comprise performing a method 500 for manufacturing a QD display screen 200 according to an arrangement of the present disclosure. With reference to Figure 5, the method 500 for manufacturing a QD display screen comprises a first step 502 in which a first layer 202 comprising a polymer substrate is provided; a second step 504, in which a second layer 204 comprising an electric circuit 204a is formed onto the first layer 202; and a third step 506, in which a third layer 206 comprising a plurality of quantum dots is formed over the second layer.

The second layer 204 may be formed on to the first layer 202 using an additive manufacturing process. For example, the electric circuit 204a may be provided using a printing process, such as an inkjet printing process, e.g. a piezoelectric inkjet or thermal inkjet (bubblejet) process, or a contact printing process. Alternatively, the electric circuit 204a may be formed using a stereolithographic manufacturing process or a deposition process, such as sputtering. Alternatively again, the second layer 204 may be formed using any other suitable process.

The third layer 206 may be formed over the second layer 204 using an additive manufacturing process. The third layer 206 may be formed directly onto the second layer 204. Alternatively, as described above, one or more intermediate layers, such as the light emitting layer 208 and/or the pigment layer 210, may be provided between the second and third layers 204, 206. In some arrangements, the third layer 206 may be formed using substantially the same process as used to form the second layer 204. For example, the third layer, e.g. the QD pixels 206a, may be printed onto the second layer 204 using a printing process, such as an inkjet process or a contact printing process. Alternatively, the third layer 206 may be formed using any other suitable process.

As described above, the second and/or third layer 204,206, and/or the light emitting layer 208 may comprise a plurality of nanowires 206c, which may electrically couple the QD pixels 206a and/or the QD solar cells 206b to the electric circuit 204a. The nanowires may be formed onto the second layer 204, third layer 206 and/or light emitting layer 208 using an additive manufacturing process, such as an inkjet process, contact printing process, stereolithography process or any other method.

One or more of the trim panels 4, 6, 8, 10, 12, 14 of the vehicle 2 may comprise apertures, e.g. for windows of the vehicle, and/or may be configured to house exterior components of the vehicle, such as lights, handles or mirrors. It may undesirable for the QD display screen 200 to be provided in the areas configured to house exterior components or where apertures are provided in the vehicle panels. The method 400 may comprise an additional step in which an aperture is provided in the QD display screen 200, corresponding to an area of the trim panel where it is undesirable to provide the QD display screen. The aperture may be provided by cutting out an area of the QD display screen.

Providing an aperture within the display screen may lead to one or more connections between the pixel controllers 204b being severed, e.g. disconnected. However, as described above, the arrangement of connections between the pixel controllers 204b may be configured to be tolerant to such disconnections.

The aperture may be provided in the QD display screen prior to the third step in which the display screen is formed onto the trim panel. Alternatively, the apertures may be formed during the third step, e.g. as the QD display screen is being formed onto the vehicle panel.

During the third step 406, the QD display screen may be formed onto the trim panel using a thermo-forming process. In order to thermo-form the display screen to the trim panel, the QD display screen may be laid over a surface of the panel. The QD display screen may be adhered to the surface of the trim panel. Once the QD display screen is appropriately positioned relative to the trim panel, the QD display screen may be heated in order to couple the QD display screen to the trim panel. Whilst the QD display screen is being heated, pressure may be applied to the QD display screen to ensure that the QD display screen conforms to any contours of the trim panel being covered. Edges of the QD display screen 200 may be cut and/or folded at edges of the trim panel.

As described above, the display controller 220 may be used to control the QD display screen 200. Hence, the method 400 may further comprise coupling the display controller 220 to the QD display screen 200. The display controller 220 may be provided at an edge of the trim panel and may be provided on a backside of the trim panel that does not display an image. The QD display screen may be wrapped around the edge of the trim panel at least where the display controller 220 is located.

In order to protect the QD display screen 200 and/or the QD display trim panel 100 from damage, e.g. from abrasion or from small objects, such as stones, hitting the vehicle 2. The QD display screen 200 and/or the QD display trim panel 100 may be provided with a protective coating at least partially over an outer surface of the QD display screen 200 and/or the QD display trim panel 100. The protective coating may be applied before the QD display screen 200 is formed onto the trim panel of the vehicle, e.g. as part of the method 500 for manufacturing the QD display screen. Alternatively, the protective coating may be applied subsequently to the QD display screen being formed onto the trim panel, e.g. as part of the method 400 for manufacturing a display trim panel for a vehicle.

When the QD display screen 200 is formed onto the trim panel of the vehicle, e.g. during the third step 406, it may be difficult to accurately control the orientation and/or position of the QD display screen 200 relative to the trim panel. This may result in each of the QD pixels 206a being provided in a different location relative to the trim panel on each of the display trim panels manufactured using the method 400. Additionally, if one or more apertures have been provided in the QD display screen 200, which have severed one or more of the connections between pixel controllers of the QD display screen, the connection routes available between the pixel controllers 204b, and hence the addresses of the pixel controllers 204b, may be different on each of the QD display trim panels 100.

In order to account for the different positions and/or orientations of the QD display screen 200 relative to the trim panel, and/or the different connection paths available between the pixel controllers 204b, once the QD display trim panel 100 has been produced, e.g. according to the method 400, it may be desirable to calibrate the QD display trim panel 100.

Calibration of the QD display trim panel 100 may be performed to allow each of the QD pixels 206a of the QD display screen 200 to be mapped to a location on the QD display trim panel 100 and/or vehicle 2. Calibration of the QD display trim panel 100 may allow the display controller 220 to control the QD pixels 206a according to their position on the QD display trim panel 100 and/or vehicle. Calibration of the QD display trim panel 100 may be particularly important when apertures have been formed in the QD display screen, as the ordering of the pixel controllers 204b in the address scheme of the QD display screen may vary.

With reference to Figure 6, the QD display trim panels 100 may be calibrated by using a method 600, according to an arrangement of the present disclosure. The method 600 comprises a first step 602, in which one or more pixels are selected to be calibrated. The pixels may be selected by determining addresses of corresponding pixel controllers of the pixels. The addresses may correspond to the pixel identities of the pixel controllers 204b. Additionally or alternatively, the addresses may correspond to the positions of the pixel controllers within the matrix of pixel controllers. Alternatively again, the address may correspond to the order in which the pixel controllers receive control signals from the display controller 220.

The method 600 comprises a second step 604, in which the QD display screen 200 is controlled to activate the selected pixels, such that the selected pixels become illuminated. In some arrangements, the QD pixels that are not selected may not be illuminated, or may be illuminated with a different, e.g. reduced, brightness. In other arrangements, the QD pixels that are not selected may be illuminated in a different colour, e.g. a contrasting colour, to the selected pixels.

In a third step 606, locations of the selected pixels relative to a location on the QD display trim panel 100 are determined. A fourth step 608 of the method 600 comprises associating the locations of the selected pixels with addresses associated with the selected pixels, e.g. according to an addressing scheme of the QD display screen 200. As described above, the addresses may correspond to a physical address of the corresponding pixel controllers 204b within the matrix of pixel controllers. Alternatively, the address may correspond to the order in which the selected pixel controller 204b receives control signals from the display controller 220. Alternatively again, the address may correspond to a pixel identity of the pixel controller 204b. The method 600 may be repeated, with different pixels being selected in the first step 602, until locations of substantially all of the pixels of the display screen have been mapped, e.g. locations of the pixels associated with the respective addresses of their corresponding pixel controllers 204b.

The number of pixels and/or the proximity of the pixels, which are selected in the first step 602, may be determined in order to allow an optimised calibration method to be implemented, e.g. such that the fewest number of iterations of the method 600 are performed in order to allow the locations of substantially all of the QD pixels to be mapped. For example, rather than illuminating a single pixel at a time, a plurality of pixels may be selected at any one time to reduce the number of calibration steps.

The locations of the selected QD pixels may be determined relative to a fixed point on the display trim panel 100. In order to determine the locations of the pixels, the method 600, e.g. the third step 606, may comprise capturing an image of the trim panel and processing the image to determine locations of the activated pixels relative to a fixed location on the QD display trim panel 100. Alternatively, the QD display trim panels 100 may be coupled to the vehicle prior to performing the calibration method 600, and the locations of each of the pixels may be determined relative to a location on the vehicle.

The display controller 220 described above may be configured to perform the calibration method 600. One or more cameras may be arranged around the QD display trim panel and may be coupled to the display controller 220 for use in the third step 606. As the display trim panel is calibrated, the associated locations and addresses of the selected pixels may be stored in a memory associated with the display controller 220.

Alternatively, a calibration controller (not shown) may be coupled to the QD display screen 200 and may perform the calibration method 600 to determine locations of one or more of the pixels. The locations determined by the calibration controller may be stored in the memory associated with the display controller 220. For example, the calibration controller may be coupled to the memory of the display controller 220 whilst performing the calibration method 600 and may store the location on the memory whilst performing the method. Alternatively, the calibration controller may store the locations on another memory and the location may be transferred to the display controller following completion of the method 600.

If the QD display trim panels 100 of the vehicle are damaged after they have been calibrated, for example due to scratches or dents being formed in the trim panels during use of the vehicle, connections between the pixel controllers 204b may be broken, which may lead to changes in the order in which control signals are received by the pixel controllers 204b of the QD display screen 200. This may result in pixels of the display screen being illuminated incorrectly. In this case, it may be desirable to recalibrate one or more of the QD display trim panels 100.

Recalibration of the QD display trim panels 100 may be performed by a garage or vehicle service provider, who may repeat the calibration method 600 described above for each of the affected QD display trim panels. Alternatively, an owner of a vehicle comprising one or more QD display trim panel 100 may recalibrate a damaged QD display trim panel by coupling a camera to the display controller 220 or vehicle display controller 20, arranging the camera to capture an image of the damaged QD display trim panel 100 and controlling the display controller 220 or vehicle controller 20 to perform the calibration method 800 using images from the camera.

As described above, the vehicle 2 may comprise a plurality of QD display trim panels 100. In some arrangements, it may be desirable for the illumination of each of the trim panels or adjacent panels to be coordinated, e.g. such that an image may be displayed continuously across multiple panels.

In some arrangements, a display controller 220 may be provided, which is coupled to each of the QD display trim panels 100 provided on the vehicle. The display controller 220 may be configured to address and control the illumination of each of the pixels on each of the display screens.

In another arrangement, each display controller 220 may be coupled to a single QD display panel and may be configured to address and control the illumination of the pixels on one QD display trim panel 100. Alternatively, each display controller 220 may be coupled to a sub-set of the QD display trim panels provided on the vehicle. For example, a display controller 220 may be coupled to and configured to control each of the display trim panels on a left side of the vehicle 2 and another display controller 220 may be provided to control the display trim panels on a right side of the vehicle.

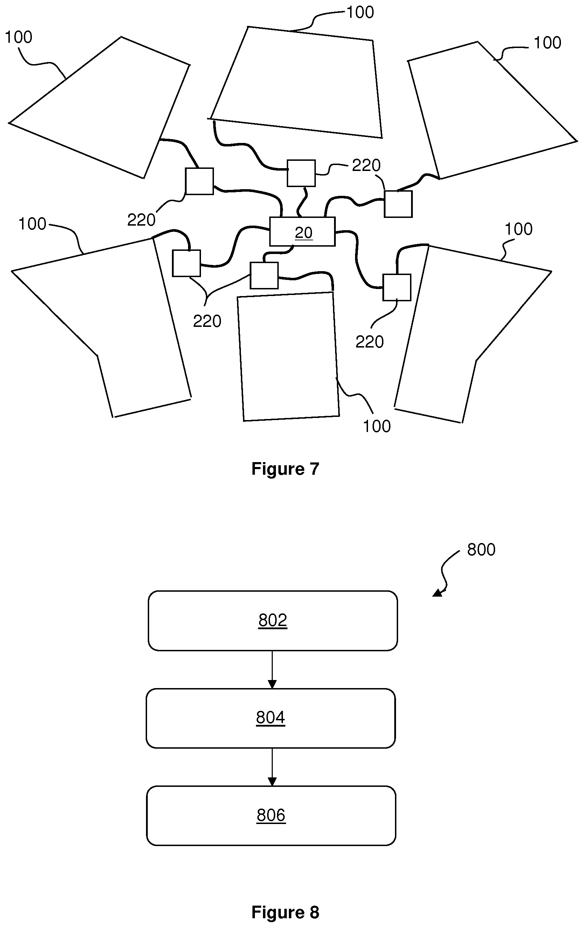

With reference to Figure 7, when more than one display controller 220 is provided on the vehicle 2, the vehicle may further comprise a vehicle display controller 20 configured to control each of the display controllers 220. As shown in Figure 7, the vehicle display controller may be coupled to each of the display controllers 220. However, in other arrangements, the vehicle display controller may be coupled, e.g. directly coupled, to one or several of the display controllers 220 and those display controller 220 may be coupled to other ones of the display controllers 220, and may be configured to relay control signals from the vehicle display controller 20 to the others display controller 220.

When a display controller 220 is provided for each QD display trim panel 100, the calibration method 600 may be performed separately for each vehicle panel. The method may be performed prior to the QD display trim panel 100 being fitted to the vehicle. Alternatively, the method 600 may be performed subsequently to the QD display trim panel 100 being fitted to the vehicle and may be performed at the same time that the method 600 is being performed for one or more other QD display trim panels 100 fitted to the vehicle.

The mapped pixel locations stored in the memories associated with each of the display controllers 220, e.g. during the calibration method 600, may allow the vehicle display controller 20 to control each of the QD display trim panels 100 to coordinate illumination of the QD display trim panels over the vehicle.

When each of the QD display trim panels 100 is provided on the vehicle 2, e.g. coupled to the vehicle 2, the relative positions of each of the QD display trim panels 100 may differ between different vehicles that are produced. With reference to Figure 8, a vehicle calibration method 800 may be performed in order to calibrate the vehicle display controller 20 to account for the variable positions of the QD display trim panels 100, e.g. to account for the gaps present between the QD display trim panels of the vehicle.

The vehicle calibration method 800 may include a first step 802, in which one or more QD pixels on one or more of the QD display trim panels 100 are illuminated. The method may further include a second step 804, in which the locations and/or orientations of the QD pixels and/or QD display trim panels are determined relative to a position on the vehicle 2. In a third step 806, the locations and/or positions of the QD pixels and/or QD display trim panels 100 may be stored in a memory associated with the vehicle display controller 20.

When a vehicle 2 comprises one or more trim panels, which are at least partially covered by a QD display screen 200 as described above, it may be desirable to illuminate one or more pixels of the QD display screen 200 during operation of the vehicle 2. For example, a user of the vehicle may control the illumination of the pixels to change the appearance of the vehicle. In some arrangements the user may select a particular colour for the vehicle, e.g. the user may configure the QD display screens 200 of the vehicle 2 such that the vehicle appears blue. The user may adjust the appearance of the vehicle 2 as desired, e.g. each day, before making a journey and/or during the journey.

In another arrangement, the user may select a pattern to be displayed over the QD display trim panels 100 of the vehicle 2. The pattern may be a static pattern, e.g. an image, or may be a dynamic pattern, such as an animated image or video. The user may upload images and/or videos to the vehicle, e.g. to a memory associated with the display controller 220 and/or the vehicle display controller 20, to be displayed on the QD display trim panels 100. Alternatively, the user may select from a library of patterns, images or videos pre-loaded onto the vehicle or made available via a networked storage facility.

In some circumstances, for example, when the vehicle 2 is parked in an owner's driveway, it may be desirable for the vehicle to adjust the illumination of the QD display screens 200 such that the vehicle 2 blends into the surrounding environment. The vehicle may comprise one or more cameras configured to capture images of the environment around the vehicle and transmit the images to the relevant display controller 220 and/or the vehicle display controller 20 to allow the captured images to be displayed on the QD display screens 200 on an opposite side of the vehicle 2, e.g. opposite to the side from which the image was captured. The cameras may be provided on the vehicle as part of another system of the vehicle or may be provided in order to generate images to be displayed on the QD display screens 200.

In some arrangements, it may be desirable to configure the QD display screen 200 to be illuminated to provide one or more lights of the vehicle 2. The lights provided by the QD display screen 200 may include, but are not limited to, side lights, reversing lights, indicator lights, such as a front, rear or side indicator light, running lights, tail lights and brake lights. By configuring the QD display screen of the vehicle to be illuminated to provide the lights of the vehicle 2, the lights may be any desirable size and/or shape, and may be arranged in any desired configuration, e.g. relative to each other, without affecting the cost and/or packaging of the lights. Additionally, the size, shape and/or arrangement of the lights may be varied as desired.

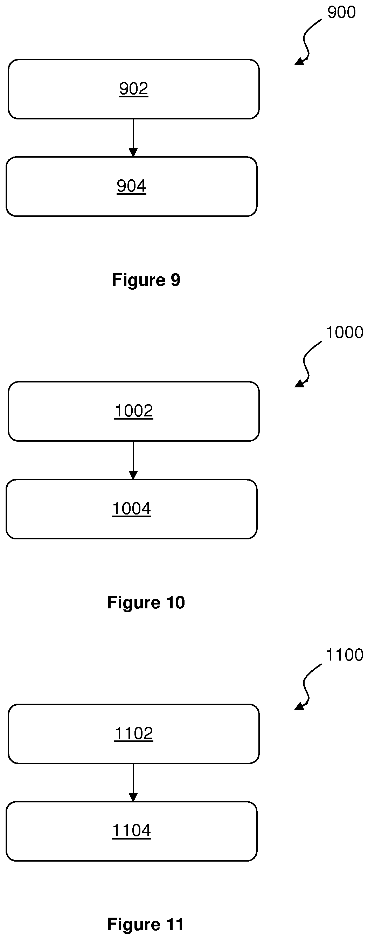

Additionally or alternatively, it may be desirable to illuminate one or more of the QD pixels of the QD display trim panel according to an operating mode of the vehicle. With reference to Figure 9, a method 900 of illuminating a display trim panel of a vehicle, according to an arrangement of the present disclosure comprises a first step 902, in which an operating mode of the vehicle is determined. The method 900 further comprises a second step 904, in which the display trim panel of the vehicle is illuminated according to the operating mode of the vehicle.

The operating mode may be one of: manual control, indicating that a driver is in control of the operation of the vehicle; semi-autonomous or autonomous control, indicating that the vehicle is operating semi-autonomously or autonomously respectively; and convoy control, indicating that the vehicle is operating as part of a convoy of vehicles. It is also envisaged that any other desirable operating mode of the vehicle may be determined and indicated by the QD display screen.

In the second step 904, the QD display screen 200 may be illuminated in order to indicate the operating mode that the vehicle is currently operating in. The operating mode may be indicated by the pattern of QD pixels which are illuminated on the QD display screen 200. Additionally or alternatively, the operating mode may be indicated according to the colour of the illuminated QD pixels of the QD display screen.

The pattern and/or colour of the illuminated pixels may be coordinated with one or more other vehicles, which are also operating in the same operating mode. For example, each of the QD display screens provided on vehicles operating in a convoy may be illuminated with the same pattern and/or colour as other vehicles operating in convoy mode, e.g. within the convoy.

The vehicles may be configured such that the QD display screens on each of the vehicles are illuminated to display a pattern extending over each of the vehicles travelling in the convoy. The pattern may vary dynamically, e.g. synchronously or sequentially, along the length of the convoy. Illuminating the QD display screens in this way may highlight to other road users which vehicles are traveling in each convoy using the road.

The pattern and/or colour of illuminated pixels may vary dynamically and the variation may be coordinated between the vehicles, e.g. such that vehicles within a convoy maintain the same pattern and/or colour of illumination as the other vehicles in the convoy. In some arrangements, the illumination of the display screens on the vehicles may be configured such that a single pattern or image appears to be applied across two of more of the vehicles in the convoy, e.g. a single pattern or image extends over two or more vehicles. The vehicles may be configured to vary the pattern and/or colour of the illumination of their QD display screens sequentially, e.g. in the order in which the vehicles are travelling in the convoy. This may allow the pattern to appear to move along the convoy, over the vehicles in the convoy. The vehicles may be configured to determine the distance between the vehicles in the convoy and the pattern may be displayed on each of the vehicles taking into account the gap between the vehicles, e.g. the gap from the vehicle in front and the vehicle behind. This may allow images in the pattern to appear to move smoothly between the vehicles in the convoy, regardless of the distances between the vehicles in the convoy.

The pattern and/or colour of QD display screens of vehicles within a convoy may differ from the pattern and/or colour of QD display screen of vehicles within a different convoy. In some circumstances, a first convoy may approach a second convoy, which is currently operating with the same pattern and/or colour of illumination as the vehicles in the first convoy. In this case, it may be desirable for the vehicles within at least one of the first and second convoys to adjust the pattern and/or colour of the illumination of their QD display screens to allow the two convoys to be visually distinguishable, e.g. to other road users. Vehicles may therefore be configured to detect other vehicles operating as part of another convoy and may be configured to adjust the pattern and/or colour of the illumination of their QD display screens such that it differs from the illumination of the QD display screen of vehicles in the other convoy. The vehicles may be configured to communicate between the convoys to ensure the same adjustments are not made by vehicles in both of the convoys. Changes of pattern and/or colour of illumination may be coordinated between the vehicles in the same convoy, such that each vehicle in the convoy continues to display the same pattern and/or colour. Vehicles comprising one or more QD display trim panels 100 may be configured to recognise and/or communicate with other vehicles provided with QD display trim panels 100. The vehicle 2 may be configured to acknowledge the other vehicles when they are traveling near to or passing them. With reference to Figure 10, a method 1000 of illuminating a QD display trim panel 100 of a vehicle, according to another arrangement of the present disclosure comprises a first step 1002, in which a location of a further vehicle comprising a QD display trim panel is determined relative to the vehicle. The method 1000 comprises a second step 1004, in which the QD display trim panel is illuminated according to the relative location of the further vehicle. For example, the pattern, colour and/or brightness of the illumination provided by the QD display trim panel may be determined according to the relative location of the further vehicle. The display trim panel may be configured to change the pattern, colour and/or brightness of the illuminated QD pixels as the vehicle 2 approaches the further vehicle. The QD display screen may be configured to change the pattern, colour and/or brightness of the illuminated QD pixels at substantially the same time that the vehicle passes the further vehicle, e.g. traveling on a road in an opposite direction.

The QD display trim panels 100 may be configured to provide indications to other road users of control inputs being provided to the vehicle 2 by a driver of the vehicle. Control inputs may comprise driving control inputs, such as brake control inputs. Additionally or alternatively, control inputs may comprise signal control inputs, such as turn indicator inputs.

With reference to Figure 11, a method 1100 of illuminating a display trim panel of a vehicle comprises a first step 1102, in which a vehicle control input is detected. The vehicle control input may be provided by a driver of the vehicle. Alternatively, the control input may be provided automatically by the vehicle, e.g. if the vehicle is operating in a semi-autonomous, autonomous or convoy driving mode. The method 1100 further comprises a second step 1104, in which the display trim panel is illuminated according to the vehicle control input.

If the vehicle control input is a vehicle brake control input, the display trim panel may be illuminated according to the braking force applied by the vehicle in response to the brake control input. For example, the colour, pattern and/or brightness of the illuminated QD pixels may be controlled according to the braking force applied by the vehicle.

The method 1100 may comprise an additional step, in which an expected manoeuvre of the vehicle is determined. The QD display trim panel 100 may be illuminated according to the expected manoeuvre of the vehicle. For example, the display trim panel may be illuminated to indicate that heavy braking is expected if the vehicle is expected to perform a turn manoeuvre that will require the vehicle to slow rapidly. Additionally or alternatively, the QD display screen 200 may be illuminated to indicate the proximity of the vehicle to the turn the vehicle is expected to take, the sharpness of the turn and/or the extent of the turn. When a manoeuvre is expected, the QD display trim panel 100 may be illuminated automatically, e.g. in anticipation of a control input being provided by the driver or automatically by the vehicle 2. Alternatively, when the vehicle is operating in manual driving mode, the QD display trim panel 100 may only by illuminated when the control input, e.g. the brake control input, is provided by the driver, even when a manoeuvre is expected.

The expected manoeuvre may be determined according to a planned or predicted route of the vehicle 2. Additionally or alternatively, the expected manoeuvre may be determined according to the proximity of the vehicle 2 to a possible turn-off from the road the vehicle is travelling along and/or any locations where U-turns may be performed. Additionally or alternatively, the expected manoeuvre may be predicted according to locations of one or more other vehicles relative to the vehicle 2. For example, if the vehicle is rapidly approaching another vehicle when a brake control input is provided by the driver, it may be determined that a hard braking manoeuvre is expected.

The method 1100 may further comprise predicting when the expected manoeuvre will be performed. The QD display trim panel 100 may be illuminated according to when the expected manoeuvre is predicted to be performed. For example, the pattern, brightness and/or colour of the illuminated QD pixels may be varied to correspond to a time until the vehicle is expected to perform a corresponding manoeuvre, e.g. the brightness may increase as the time of the expected manoeuvre approaches.

## Claims

1. A Quantum Dot display screen (200) for a trim panel (4, 6, 8, 10, 12, 14) of a motor vehicle (2), the display screen comprising:
a first layer (202) comprising a formable polymer substrate;
wherein the display screen (200) is configured to be formed onto the trim panel (4, 6, 8, 10) of the vehicle such that the display screen follows the visible contours of the trim panel, the display screen at least partially covering the trim panel,
**characterised in that** the display screen (200) further comprises:
a second layer (204) comprising an electric circuit (204a), wherein the second layer (204) is formed onto the first layer (202); and
a third layer (206) comprising a plurality of quantum dots configured to emit light, the electric circuit (204a) configured to control the emission of light from the quantum dots;
wherein one or more of the quantum dots are configured to absorb light and generate a voltage across the one or more quantum dots.

2. The display screen (200) according to claim 1, wherein the display screen further comprises a light emitting layer (208) comprising a plurality of light emitting elements, wherein the light emitting layer is provided between the second layer (204) and the third layer (206).

3. The display screen (200) according to claim 1 or 2, wherein the display screen comprises a plurality of Quantum Dot pixels (206a), each Quantum Dot pixel (206a) comprising one or more quantum dots.

4. The display screen (200) according to claim 3, wherein each of the Quantum Dot pixels (206a) comprises one or more electro-active Quantum Dot elements (206a'), the electro-active Quantum Dot elements (206a') comprising one or more quantum dots, wherein the electro-active Quantum Dot elements are configured to receive a signal from the electric circuit (204a) and emit light.

5. The display screen (200) according to any of the preceding claims, wherein the display screen further comprises a pigment layer (210), such as a pigment layer provided between the second layer (204) and the third layer (206).

6. The display screen (200) according to any of claims 3 to 5 when depending on claim 3, wherein the second layer (204) comprises a plurality of pixel controllers (204b), wherein each of the pixel controllers (204b) is configured to control a respective Quantum Dot pixel.

7. The display screen (200) according to claim 6, wherein each of the pixel controllers (204b) is communicatively coupled to at least two other pixel controllers and/or wherein each of the pixel controllers (204b) is communicatively coupled to the other pixel controllers within a matrix.

8. The display screen (200) according to any of the preceding claims, wherein the electric circuit (204a) is configured to receive electrical power from the third layer (206), e.g. to charge an energy storage device coupled to the electric circuit (204a).

9. The display screen (200) according to any of the preceding claims, wherein the Quantum Dot display screen is configured to be illuminated to provide one or more lights of the motor vehicle (2).

10. A method of manufacturing a display trim panel for a vehicle (2), the method comprising:
manufacturing a Quantum Dot display screen (200), wherein manufacturing the Quantum Dot display screen comprises:
providing a first layer (202) comprising a formable polymer substrate;
forming a second layer (204) onto the polymer substrate, wherein the second layer comprises an electric circuit (204a); and
forming a third layer (206) over the second layer (204), wherein the third layer comprises a plurality of quantum dots configured to emit light, the electric circuit (204a) configured to control the emission of light, and wherein one or more of the quantum dots are configured to absorb light and generate a voltage across the one or more quantum dots;
wherein the method of manufacturing the display trim panel further comprises:
providing a trim panel (4, 6, 8, 10, 12, 14) of the vehicle (2); and
forming the Quantum Dot display screen (200) on to the trim panel, such that the display screen follows the visible contours of the trim panel, the display screen at least partially covering the trim panel.

11. The method according to claim 10, wherein the method further comprises, providing an aperture in the display screen, e.g. by cutting the Quantum Dot display screen (200).

12. The method according to claim 10 or 11, wherein the method further comprises calibrating a display screen controller (220) according to the position and/or orientation of the display screen (200) relative to the trim panel (4, 6, 8, 10, 12, 14) and/or vehicle (2).

13. The method of claim 12, wherein the method further comprises:
(a) selecting one or more pixels of the display screen (200) to be calibrated;
(b) controlling the display screen (200) to activate the selected pixels, such that the selected pixels becomes illuminated;
(c) determining locations of the selected pixels relative to a location on the trim panel (4, 6, 8, 10, 12, 14) and/or vehicle (20); and
(d) associating the locations of the selected pixels with addresses associated with the selected pixels.

14. The method according to claim 13, wherein step (c) comprises:
capturing an image of the trim panel (4, 6, 8, 10, 12, 14) or vehicle (2); and
processing the image to determine locations of the activated pixels relative to a location on the trim panel or vehicle.

## Patentansprüche

1. Quantenpunktanzeigebildschirm (200) für ein Verkleidungspaneel (4, 6, 8, 10, 12, 14) eines Kraftfahrzeugs (2), wobei der Anzeigebildschirm Folgendes umfasst:
eine erste Schicht (202), die ein formbares Polymersubstrat umfasst;
wobei der Anzeigebildschirm (200) dazu ausgelegt ist, auf ein Verkleidungspaneel (4, 6, 8, 10) des Fahrzeugs derart geformt zu werden, dass der Anzeigebildschirm den sichtbaren Konturen des Verkleidungspaneels folgt, wobei der Anzeigebildschirm das Verkleidungspaneel mindestens teilweise abdeckt,
**dadurch gekennzeichnet, dass** der Anzeigebildschirm (200) ferner Folgendes umfasst:
eine zweite Schicht (204), die eine elektrische Schaltung (204a) umfasst, wobei die zweite Schicht (204) auf die erste Schicht (202) geformt ist; und
eine dritte Schicht (206), die eine Vielzahl von Quantenpunkten umfasst, die dazu ausgelegt sind, Licht zu emittieren, wobei die elektrische Schaltung (204a) dazu ausgelegt ist, die Emission von Licht von den Quantenpunkten zu steuern;
wobei ein oder mehrere der Quantenpunkte dazu ausgelegt sind, Licht zu absorbieren und über den einen oder die mehreren Quantenpunkte eine Spannung zu erzeugen.

2. Anzeigebildschirm (200) nach Anspruch 1, wobei der Anzeigebildschirm ferner eine lichtemittierende Schicht (208) umfasst, die eine Vielzahl von lichtemittierenden Elementen umfasst, wobei die lichtemittierende Schicht zwischen der zweiten Schicht (204) und der dritten Schicht (206) bereitgestellt ist.

3. Anzeigebildschirm (200) nach Anspruch 1 oder 2, wobei der Anzeigebildschirm eine Vielzahl von Quantenpunktpixeln (206a) umfasst, wobei jedes Quantenpunktpixel (206a) einen oder mehrere Quantenpunkte umfasst.

4. Anzeigebildschirm (200) nach Anspruch 3, wobei jedes der Quantenpunktpixel (206a) ein oder mehrere elektroaktive Quantenpunktelemente (206a') umfasst, wobei die elektroaktiven Quantenpunktelemente (206a') einen oder mehrere Quantenpunkte umfassen, wobei die elektroaktiven Quantenpunktelemente dazu ausgelegt sind, ein Signal von der elektrischen Schaltung (204a) zu empfangen und Licht zu emittieren.

5. Anzeigebildschirm (200) nach einem der vorhergehenden Ansprüche, wobei der Anzeigebildschirm ferner eine Pigmentschicht (210) umfasst, wie etwa eine Pigmentschicht, die zwischen der zweiten Schicht (204) und der dritten Schicht (206) bereitgestellt ist.

6. Anzeigebildschirm (200) nach einem der Ansprüche 3 bis 5, wenn von Anspruch 3 abhängig, wobei die zweite Schicht (204) eine Vielzahl von Pixelsteuerungen (204b) umfasst, wobei jede der Pixelsteuerungen (204b) dazu ausgelegt ist, ein jeweiliges Quantenpunktpixel zu steuern.

7. Anzeigebildschirm (200) nach Anspruch 6, wobei jede Pixelsteuerung (204b) kommunikativ an mindestens zwei weitere Pixelsteuerungen gekoppelt ist und/oder wobei jede der Pixelsteuerungen (204b) innerhalb einer Matrix kommunikativ an die anderen Pixelsteuerungen gekoppelt ist.

8. Anzeigebildschirm (200) nach einem der vorhergehenden Ansprüche, wobei die elektrische Schaltung (204a) dazu ausgelegt ist, elektrischen Strom von der dritten Schicht (206) zu empfangen, z. B. um eine Energiespeichervorrichtung, die an die elektrische Schaltung (204a) gekoppelt ist, zu laden.

9. Anzeigebildschirm (200) nach einem der vorhergehenden Ansprüche, wobei der Quantenpunktanzeigebildschirm dazu ausgelegt ist, beleuchtet zu werden, um eine oder mehrere Leuchten des Kraftfahrzeugs (2) bereitzustellen.

10. Verfahren zum Herstellen eines Anzeigeverkleidungspaneels für ein Fahrzeug (2), wobei das Verfahren Folgendes umfasst:
Herstellen eines Quantenpunktanzeigebildschirms (200), wobei das Herstellen des Quantenpunktanzeigebildschirms Folgendes umfasst:
Bereitstellen einer ersten Schicht (202), die ein formbares Polymersubstrat umfasst;
Formen einer zweiten Schicht (204) auf das Polymersubstrat, wobei die zweite Schicht eine elektrische Schaltung (204a) umfasst; und
Formen einer dritten Schicht (206) über die zweite später (204), wobei die dritte Schicht eine Vielzahl von Quantenpunkten umfasst, die dazu ausgelegt sind, Licht zu emittieren, wobei die elektrische Schaltung (204a) dazu ausgelegt ist, die Emission von Licht zu steuern, und wobei ein oder mehrere der Quantenpunkte dazu ausgelegt sind, Licht zu absorbieren und über den einen oder die mehreren Quantenpunkte eine Spannung zu erzeugen;
wobei das Verfahren des Herstellens des Anzeigeverkleidungspaneels ferner Folgendes umfasst:
Bereitstellen eines Verkleidungspaneels (4, 6, 8, 10, 12, 14) des Fahrzeugs (2) und
Formen des Quantenpunktanzeigebildschirms (200) auf das Verkleidungspaneel, derart, dass der Anzeigebildschirm den sichtbaren Konturen des Verkleidungspaneels folgt, wobei der Anzeigebildschirm das Verkleidungspaneel mindestens teilweise abdeckt.

11. Verfahren nach Anspruch 10, wobei das Verfahren ferner das Bereitstellen einer Öffnung im Anzeigebildschirm, z. B. durch Schneiden des Quantenpunktanzeigebildschirms (200), umfasst.

12. Verfahren nach Anspruch 10 oder 11, wobei das Verfahren das Kalibrieren einer Anzeigebildschirmsteuerung (220) gemäß der Position und/oder der Ausrichtung des Anzeigebildschirms (200) relativ zum Verkleidungspaneel (4, 6, 8, 10, 12, 14) und/oder zum Fahrzeug (2) umfasst.

13. Verfahren nach Anspruch 12, wobei das Verfahren ferner Folgendes umfasst:
(a) Auswählen von einem oder mehreren Pixeln des zu kalibrierenden Anzeigebildschirms (200);
(b) Steuern des Anzeigebildschirms (200), um die ausgewählten Pixel zu aktivieren, derart, dass die ausgewählten Pixel beleuchtet werden;
(c) Bestimmen von Lagen der ausgewählten Pixel relativ zu einer Lage am Verkleidungspaneel (4, 6, 8, 10, 12, 14) und/oder am Fahrzeug (20) und
(d) Verknüpfen der Lagen der ausgewählten Pixel mit Adressen, die mit den ausgewählten Pixeln verknüpft sind.

14. Verfahren nach Anspruch 13, wobei Schritt (c) Folgendes umfasst:
Erfassen eines Bildes des Verkleidungspaneels (4, 6, 8, 10, 12, 14) oder des Fahrzeugs (2) und
Verarbeiten des Bildes, um Lagen der aktivierten Pixel relativ zu einer Lage am Verkleidungspaneel oder am Fahrzeug zu bestimmen.

## Revendications

1. Un écran d'affichage à points quantiques (200) pour un panneau de garniture (4, 6, 8, 10, 12, 14) d'un véhicule à moteur (2), l'écran d'affichage comprenant :
une première couche (202) comprenant un substrat polymère formable ;
dans lequel l'écran d'affichage (200) est configuré pour être formé sur le panneau de garniture (4, 6, 8, 10) du véhicule de sorte que l'écran d'affichage suit les contours visibles du panneau de garniture, l'écran d'affichage couvrant au moins partiellement le panneau de garniture,
**caractérisé en ce que** l'écran d'affichage (200) comprend en outre :
une deuxième couche (204) comprenant un circuit électrique (204a), dans lequel la deuxième couche (204) est formée sur la première couche (202) ; et
une troisième couche (206) comprenant une pluralité de points quantiques configurés pour émettre de la lumière, le circuit électrique (204a) configuré pour contrôler l'émission de lumière à partir des points quantiques ;
dans lequel un ou plusieurs des points quantiques sont configurés pour absorber la lumière et générer une tension à travers un ou plusieurs points quantiques.

2. L'écran d'affichage (200) selon la revendication 1, dans lequel l'écran d'affichage comprend en outre une couche émettrice de lumière (208) comprenant une pluralité d'éléments émetteurs de lumière, dans lequel la couche émettrice de lumière est prévue entre la deuxième couche (204) et la troisième couche (206).

3. L'écran d'affichage (200) selon la revendication 1 ou 2, dans lequel l'écran d'affichage comprend une pluralité de pixels de points quantiques (206a), chaque pixel de points quantiques (206a) comprenant un ou plusieurs points quantiques.

4. L'écran d'affichage (200) selon la revendication 3, dans lequel chacun des pixels de points quantiques (206a) comprend un ou plusieurs éléments de points quantiques électroactifs (206a'), les éléments de points quantiques électroactifs (206a') comprenant un ou plusieurs points quantiques, dans lequel les éléments de points quantiques électroactifs sont configurés pour recevoir un signal à partir du circuit électrique (204a) et émettre de la lumière.

5. L'écran d'affichage (200) selon l'une quelconque des revendications précédentes, dans lequel l'écran d'affichage comprend en outre une couche de pigment (210), telle qu'une couche de pigment prévue entre la deuxième couche (204) et la troisième couche (206).

6. L'écran d'affichage (200) selon l'une quelconque des revendications 3 à 5 lorsqu'elles dépendent de la revendication 3, dans lequel la deuxième couche (204) comprend une pluralité de contrôleurs de pixels (204b), dans lequel chacun des contrôleurs de pixels (204b) est configuré pour contrôler un pixel de points quantiques respectif.

7. L'écran d'affichage (200) selon la revendication 6, dans lequel chacun des contrôleurs de pixels (204b) est couplé en communication à au moins deux autres contrôleurs de pixels et / ou dans lequel chacun des contrôleurs de pixels (204b) est couplé en communication aux autres contrôleurs de pixels dans une matrice.

8. L'écran d'affichage (200) selon l'une quelconque des revendications précédentes, dans lequel le circuit électrique (204a) est configuré pour recevoir de l'énergie électrique à partir de la troisième couche (206), par exemple pour charger un dispositif de stockage d'énergie couplé au circuit électrique (204a).

9. L'écran d'affichage (200) selon l'une quelconque des revendications précédentes, dans lequel l'écran d'affichage à points quantiques est configuré pour être illuminé afin de fournir une ou plusieurs lumières du véhicule à moteur (2).

10. Un procédé de fabrication d'un panneau de garniture d'affichage pour un véhicule (2), le procédé comprenant :
la fabrication d'un écran d'affichage à points quantiques (200), dans lequel la fabrication de l'écran d'affichage à points quantiques comprend :
la fourniture d'une première couche (202) comprenant un substrat polymère formable ;
la formation d'une deuxième couche (204) sur le substrat polymère, dans lequel la deuxième couche comprend un circuit électrique (204a) ; et
la formation d'une troisième couche (206) sur la deuxième couche (204), dans lequel la troisième couche comprend une pluralité de points quantiques configurés pour émettre de la lumière, le circuit électrique (204a) configuré pour contrôler l'émission de lumière, et dans lequel un ou plusieurs des points quantiques sont configurés pour absorber la lumière et générer une tension à travers le ou les points quantiques ;
dans lequel le procédé de fabrication du panneau de garniture d'affichage comprend en outre :
la fourniture d'un panneau de garniture (4, 6, 8, 10, 12, 14) du véhicule (2) ; et
la formation de l'écran d'affichage à points quantiques (200) sur le panneau de garniture, de sorte que l'écran d'affichage suit les contours visibles du panneau de garniture, l'écran d'affichage couvrant au moins partiellement le panneau de garniture.

11. Le procédé selon la revendication 10, dans lequel le procédé comprend en outre la fourniture d'une ouverture dans l'écran d'affichage, par exemple en coupant l'écran d'affichage à points quantiques (200).

12. Le procédé selon la revendication 10 ou 11, dans lequel le procédé comprend en outre l'étalonnage d'un contrôleur d'écran d'affichage (220) selon la position et / ou l'orientation de l'écran d'affichage (200) par rapport au panneau de garniture (4, 6, 8, 10, 12, 14) et / ou au véhicule (2).

13. Le procédé selon la revendication 12, dans lequel le procédé comprend en outre :
(a) la sélection d'un ou plusieurs pixels de l'écran d'affichage (200) à étalonner ;
(b) le contrôle de l'écran d'affichage (200) pour activer les pixels sélectionnés, de sorte que les pixels sélectionnés s'illuminent ;
(c) la détermination des emplacements des pixels sélectionnés par rapport à un emplacement sur le panneau de garniture (4, 6, 8, 10, 12, 14) et /ou le véhicule (20) ; et
(d) l'association des emplacements des pixels sélectionnés aux adresses associées aux pixels sélectionnés.

14. Le procédé selon la revendication 13, dans lequel l'étape (c) comprend :
la capture d'une image du panneau de garniture (4, 6, 8, 10, 12, 14) ou du véhicule (2) ; et
le traitement de l'image pour déterminer les emplacements des pixels activés par rapport à un emplacement sur le panneau de garniture ou sur le véhicule.
